# FASCICULE DE BREVET EUROPEEN

(11) **EP 1 137 826 B1**
(45) Date de publication et mention de la délivrance du brevet: **19.03.2003**
(21) Numéro de dépôt: 99973081.5
(22) Date de dépôt: 01.12.1999
(51) Int. Cl.: C30B 33/00, C30B 25/02, C30B 29/04, C30B 29/36

(54) **COUCHE MONOATOMIQUE ET MONOCRISTALLINE DE GRANDE TAILLE, EN CARBONE DE TYPE DIAMANT, ET PROCEDE DE FABRICATION DE CETTE COUCHE**
GROSSFLÄCHIGE EINKRISTALLINE MONOATOMSCHICHT AUS KOHLENSTOFF VOM DIAMANT-TYP UND VERFAHREN ZU IHRER HERSTELLUNG
LARGE-SIZE MONOATOMIC AND MONOCRYSTALLINE LAYER, MADE OF DIAMOND-TYPE CARBON AND DEVICE FOR MAKING SAME

(30) Priorité: 02.12.1998 FR 9815218
(43) Date de publication de la demande: 04.10.2001
(73) Titulaire: COMMISSARIAT A L'ENERGIE ATOMIQUE, 75752 Paris Cédex 15 (FR); CENTRE NATIONAL DE LA RECHERCHE SCIENTIFIQUE (CNRS), 75794 Paris Cedex 16 (FR)
(72) Inventeur: DERYCKE, Vincent, F-78230 Le Pecq (FR); DUJARDIN, Gérald, F-92290 Châtenay Malabry (FR); MAYNE, Andrew, F-92160 Antony (FR); SOUKIASSIAN, Patrick, F-78470 Saint Rémy Les Chevreuse (FR)
(74) Mandataire: Brykman, Georges
(86) Numéro de dépôt international: FR9902979
(87) Numéro de publication internationale: WO00032853

(56) Documents cités:
- FR-A- 2 757 183
- PATENT ABSTRACTS OF JAPAN vol. 016, no. 362 (C-0971), 5 août 1992 (1992-08-05) & JP 04 114995 A (MATSUSHITA ELECTRIC IND CO LTD), 15 avril 1992 (1992-04-15)
- PATENT ABSTRACTS OF JAPAN vol. 016, no. 329 (C-0963), 17 juillet 1992 (1992-07-17) & JP 04 092893 A (FUAIN SERAMITSUKUSU SENTAA), 25 mars 1992 (1992-03-25)
- KACKELL P ET AL: "Polytypism and surface structure of SiC" DIAMOND AND RELATED MATERIALS, vol. 6, no. 10, 1 août 1997 (1997-08-01), page 1346-1348 XP004096938 ISSN: 0925-9635
- KAWARADA H ET AL: "HETEROEPITAXIAL GROWTH OF SMOOTH AND CONTINUOUS DIAMOND THIN FILMS ON SILICON SUBSTRATES VIA HIGH QUALITY SILICON CARBIDE BUFFER LAYERS" APPLIED PHYSICS LETTERS, vol. 66, no. 5, 30 janvier 1995 (1995-01-30), pages 583-585, XP000489804 ISSN: 0003-6951

## Description

### DOMAINE TECHNIQUE

La présente invention concerne une couche monoatomique et monocristalline en carbone de type diamant, ainsi qu'un procédé de fabrication de cette couche.

### ÉTAT DE LA TECHNIQUE ANTÉRIEURE

Le diamant existe à l'état naturel mais est très rare et coûteux. De plus, les diamants naturels disponibles ont des dimensions relativement faibles, ce qui limite leur emploi dans l'industrie, leur principal débouché restant la joaillerie.

Ceci a conduit à rechercher des procédés de fabrication artificielle du diamant.

En effet, le diamant est, de très loin, le meilleur semiconducteur possible pour l'industrie électronique. Il surclasse le silicium et les composés semiconducteurs III-V d'au moins quatre ordres de grandeur en termes de facteur de qualité (en particulier en ce qui concerne l'électronique rapide, les grandes puissances et les hautes températures).

C'est aussi un matériau biocompatible et d'une grande dureté.

Toutefois, pour pouvoir l'utiliser, il faut impérativement disposer de monocristaux de diamant ayant des tailles suffisantes, surtout dans le domaine de la micro-électronique.

Les procédés de synthèse mis au point jusqu'à présent font intervenir des conditions de croissance extrêmes : hautes pressions, hautes températures, plasmas, dépôts chimiques en phase vapeur et techniques de détonation de TNT.

Il en résulte la fabrication de cristaux qui ont de faibles dimensions (les plus petits ne mesurent pas plus de 4 nm) et dont l'assemblage n'a pas permis l'obtention de cristaux de plus grandes dimensions.

### EXPOSÉ DE L'INVENTION

La présente invention a pour but de remédier aux inconvénients précédents et propose, pour ce faire, une structure ayant des propriétés électroniques, chimiques et structurales proches de celles du diamant, ce qui permet d'obtenir une base sur laquelle la croissance de couches de diamant peut avoir lieu dans les mêmes conditions : même élément chimique (le carbone), mêmes propriétés électroniques (configuration sp³) et désaccord de maille le plus faible possible entre le substrat et le cristal de diamant.

De façon précise, la présente invention a pour objet une couche monoatomique et monocristalline de carbone de type diamant, cette couche étant caractérisée en ce qu'elle est formée sur la surface d'un substrat monocristallin en SiC et s'étend sensiblement sur la totalité de ce substrat.

Selon un premier mode de réalisation particulier de la couche monoatomique et monocristalline objet de l'invention, le substrat monocristallin en SiC est une couche mince de SiC monocristallin en phase cubique β-SiC (100) formée sur une plaquette (« wafer ») de Si, la couche monoatomique et monocristalline recouvrant ainsi sensiblement la totalité de cette plaquette.

Selon un deuxième mode de réalisation particulier, le substrat monocristallin en SiC est une plaquette de SiC monocristallin en phase hexagonale, la couche monoatomique et monocristalline recouvrant ainsi sensiblement la totalité de cette plaquette.

A partir de la couche monoatomique et monocristalline objet de l'invention, on peut obtenir une couche monocristalline de diamant qui surmonte la couche monoatomique et monocristalline et qui est formée par croissance à partir de cette couche monoatomique et monocristalline, cette dernière servant de matrice.

La présente invention a également pour objet un procédé de fabrication d'une couche monoatomique et monocristalline de carbone de type diamant, ce procédé étant caractérisé en ce qu'on forme un substrat monocristallin en Sic terminé par un plan atomique de carbone selon une reconstruction c(2x2), ce plan étant un plan de dimères carbone-carbone de configuration sp, et en ce qu'on effectue au moins un recuit de ce substrat, ce recuit étant apte à transformer le plan de dimères carbone-carbone de configuration sp en un plan de dimères carbone-carbone de configuration sp³ formant ainsi une couche monoatomique et monocristalline de carbone de type diamant.

Selon un premier mode de mise en oeuvre particulier du procédé objet de l'invention, le substrat monocristallin en SiC est préparé à partir d'une couche mince de SiC monocristallin en phase cubique β-SiC ayant une face (100) terminée par une couche de Si.

Selon un deuxième mode de mise en oeuvre particulier, le substrat monocristallin en SiC est préparé à partir d'une couche mince d'une plaquette de SiC monocristallin en phase hexagonale ayant une face (1000) terminée par une couche de Si.

Pour obtenir le plan atomique de carbone selon la reconstruction c(2x2), on peut effectuer un recuit apte à éliminer la couche de Si ou effectuer un dépôt de molécules hydrocarbonées sur la couche de Si puis un craquage (« cracking ») de ces molécules.

Les molécules hydrocarbonées peuvent être choisies dans le groupe comprenant les molécules de C₂H₄ et les molécules de C₂H₂.

Selon un mode de-mise en oeuvre particulier de l'invention, pour transformer le plan de dimères carbone-carbone de configuration sp en un plan de dimères carbone-carbone de configuration sp³, on effectue un recuit ou une pluralité de recuits successifs, à une température environ égale à 1250°C, du substrat monocristallin en SiC terminé par le plan atomique de carbone selon la reconstruction c(2x2), la durée totale de recuit étant supérieure ou environ égale à 25 minutes.

La présente invention permet de disposer d'un substrat ayant des caractéristiques très voisines de celles du diamant : même élément chimique (le carbone), même type de liaison (sp³), même propriétés électroniques et même structure à ceci près que le paramètre de maille du substrat est plus grand que celui du diamant.

Ce substrat présente néanmoins le plus faible désaccord de maille possible avec le diamant quand on le compare à d'autres substrats tels que le silicium ou certains isolants.

Le contrôle, à l'échelle atomique, de la phase de nucléation sur une surface de SiC terminée carbone conformément à l'invention permet d'avoir un motif structural désiré identique à celui du diamant.

On dispose donc, à l'échelle atomique, d'une matrice permettant de faire croître une couche plus épaisse, monocristalline, de diamant.

Cette matrice est susceptible d'avoir une grande surface, comparable à celle des plaquettes de silicium ou de carbure de silicium.

Il convient de noter que l'invention a été rendue possible par la parfaite maîtrise, à l'échelle atomique, des différentes compositions et reconstructions des surfaces du β-SiC (100), en particulier les surfaces de β-SiC (100) 3x2, β-SiC (100) c(4x2) et β-SiC (100) c(2x2).

A ce sujet, on consultera les documents [1] à [10] qui, comme les autres documents cités par la suite, sont mentionnés à la fin de la présente description.

Des travaux de microscopie à effet tunnel ont confirmé l'idée que les surfaces obtenues étaient, contrairement à toute attente et compte tenu de l'état de la technique, (a) de très grande qualité (comparable à celle qui est obtenue sur les surfaces de silicium), avec une faible densité de défauts, (b) plates et (c) sans ondulations (« corrugations »).

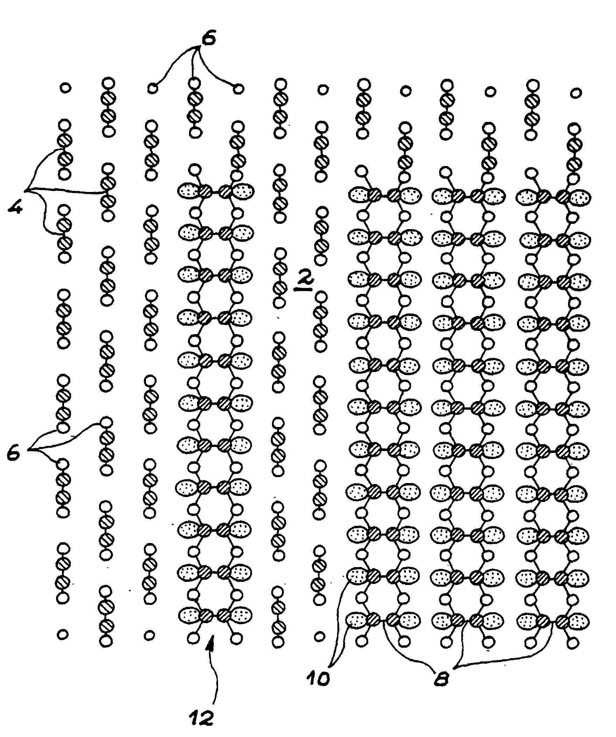

### BRÈVE DESCRIPTION DU DESSIN

La présente invention sera mieux comprise à la lecture de la description d'exemples de réalisation donnés ci-après, à titre purement indicatif et nullement limitatif, en faisant référence à la figure unique annexée qui est une vue de dessus schématique d'une couche monoatomique et monocristalline de carbone de type diamant conforme à l'invention, en cours de formation.

### EXPOSÉ DÉTAILLÉ DE MODES DE RÉALISATION PARTICULIERS

La fabrication d'une couche monoatomique et monocristalline de carbone de type diamant conforme à l'invention est par exemple effectuée dans une enceinte étanche (non représentée), maintenue à une pression inférieure à 5x10⁻⁹ Pa ou sous atmosphère neutre.

On utilise par exemple un substrat de carbure de silicium constitué par un film monocristallin très mince, d'une épaisseur de l'ordre 1 µm, de carbure de silicium en phase cubique β-SiC (100).

Ce substrat peut être obtenu par dépôt chimique en phase vapeur d'une premier composé gazeux contenant du carbone et d'un deuxième composé gazeux contenant du silicium sur une surface vicinale de Si (100) désorientée de 4°.

A titre d'exemple, le premier composé gazeux est C₃H₈ et le deuxième composé gazeux est SiH₄.

On peut aussi utiliser, en tant que substrat, un monocristal de SiC massif.

A ce sujet, on consultera les documents [5], [6] et [7] .

A partir de ce substrat dont la surface est terminée Si (c'est-à-dire terminée par une couche atomique de silicium) on prépare ensuite une surface de carbure de silicium cubique (β-SiC (100)) terminée par un plan atomique de carbone selon une reconstruction c(2x2).

A ce sujet on consultera les documents [11], [12], [13] et [14].

Pour préparer cette surface, on élimine sélectivement le plan de silicium par recuit thermique à une température d'environ 1200 °C pendant environ 10 minutes.

Au lieu de cela on peut effectuer, sur la couche de silicium, un dépôt de molécules hydrocarbonées, par exemple un dépôt de molécules de C₂H₄ ou de C₂H₂, puis un craquage de ces molécules à 950 °C.

A ce sujet on consultera les documents [1] à [4] et [11] à [14].

On obtient ainsi la surface terminée C, c'est-à-dire terminée par un plan atomique de carbone, et reconstruite c(2x2).

Ce plan atomique de carbone est un plan de dimères carbone - carbone de configuration sp : dans chaque dimère les deux atomes de carbone sont liés par une triple liaison C≡C.

Ensuite, pour obtenir la couche monoatomique de carbone de type diamant, on transforme le plan de dimères de configuration sp en un plan de dimères carbone - carbone de configuration sp³.

Pour ce faire, on effectue un recuit ou une pluralité de recuits successifs de la surface, la température de recuit et la durée totale de recuit étant choisies pour recouvrir la surface de ces dimères de configuration sp³.

A titre d'exemple, on effectue un seul recuit à environ 1250 °C pendant au moins 25 minutes ou plusieurs recuits successifs à environ 1250 °C pendant des temps respectifs dont le total vaut au moins 25 minutes (par exemple deux recuits à 1250 °C, le premier pendant 15 minutes et le deuxième pendant 23 minutes).

Au lieu de cela on pourrait chauffer le substrat pendant moins de 25 minutes mais à une température supérieure à 1250 °C .

La figure unique annexée est une vue de dessus schématique de la couche de carbone de type diamant conforme à l'invention en cours de formation sur un substrat 2 en SiC.

On voit les dimères C≡C de type sp qui ont la référence 4 et, en dessous de ceux-ci, les atomes de silicium qui ont la référence 6.

Lors du recuit ou des recuits successifs il se produit une rupture des liaisons triples et un réarrangement des atomes de carbone pour former des liaisons simples sous la forme de dimères C-C de type sp³, qui ont la référence 8, ces liaisons simples étant perpendiculaires aux liaisons triples précédentes, la référence 10 correspondant à la liaison pendante de chaque dimère C-C.

On obtient ainsi des chaînes d'atome de carbone telles que la chaîne 12 et, avec une durée suffisante du recuit ou avec une séquence de recuits de durée totale suffisante, le nombre de chaînes d'atomes de carbone augmente pour arriver à un état où ces atomes de carbone couvrent toute la surface du substrat 2 pour former une couche monoatomique et monocristalline de carbone de type diamant.

On dispose ainsi d'un procédé relativement simple (recuit thermique ou séquence de recuits thermiques) sur un matériau commercialement disponible à savoir le carbure de silicium cubique.

Celui-ci existe dans le commerce sous la forme de couches minces sur des plaquettes de silicium de 10 cm de diamètre.

L'invention permet donc la croissance de cristaux de diamant ayant des dimensions comparables à celles des autres semiconducteurs.

Dans l'exemple considéré, on a utilisé une face (100) d'un substrat de SiC mais au lieu de cela on pourrait utiliser une face (111).

De plus, dans cet exemple, on a utilisé un substrat de carbure de silicium cubique mais l'invention peut aussi être mise en oeuvre avec un substrat de carbure de silicium hexagonal avec une face (1000) terminée Si.

Cette face a la même structure que le β-SiC (111) cubique.

A ce sujet on consultera le document [1].

Il convient de noter que des plaquettes de monocristaux de carbure de silicium hexagonal (phases 4H et 6H) de 0,5 mm d'épaisseur sont commercialement disponibles, avec des diamètres allant jusqu'à trois pouces (environ 7,5 cm).

Lorsqu'on a fabriqué une couche monoatomique et monocristalline de carbone de type diamant conformément à l'invention, on est capable de faire croître, sur cette couche, une couche monocristalline de diamant par une méthode connue. A ce sujet on consultera par exemple le document [15].

### APPLICATIONS INDUSTRIELLES

Les domaines d'application de la présente invention sont extrêmement étendus : micro-électronique, optoélectronique, micromécanique et biomatériaux (prothèses).

En électronique, le diamant est potentiellement le meilleur semiconducteur possible avec des caractéristiques exceptionnelles. Il est susceptible de conduire à la fabrication de dispositifs ayant des performances jamais atteintes.

En optoélectronique, le diamant est un matériau dont la surface peut fonctionner en régime d'électro-affinité négative, ce qui présente un grand intérêt pour des photocathodes ultra-sensibles (en particulier pour la vision nocturne et pour les caméras vidéo). De plus, ces propriétés d'électro-affinité négative sont susceptibles de conduire à la réalisation de cathodes à micropointes (« microtips ») pour l'émission par effet de champ, cathodes avec lesquelles on peut réaliser des écrans vidéo plats.

Le diamant est aussi un excellent matériau utilisable dans la réalisation de détecteurs de rayons X.

De plus, en micromécanique, le diamant peut fournir des revêtements très durs.

Et, dans le domaine des biomatériaux, le diamant est sinon le meilleur du moins l'un des meilleurs matériaux biocompatibles et peut servir de base à la fabrication de prothèses ou d'implants.

Le développement de techniques microélectroniques avec le diamant nécessite de disposer de substrats en diamant de grande taille, ce que permet la présente invention.

Les documents cités dans la présente description sont les suivants :
[1] P. Soukiassian, F. Semond, L. Douillard, A. Mayne, G. Dujardin, l. Pizzagalli et C. Joachim, Phys. Rev. Lett. 78, 907 (1997).
[2] V. Yu Aristov, L. Douillard, O. Fauchoux et P. Soukiassian, Phys. Rev. Lett. 79, 3700 (1997).
[3] P. Soukiassian, F. Semond, A. Mayne et G. Dujardin, Phys. Rev. Lett. 79, 2498 (1997).
[4] G. Dujardin, A. Mayne, F. Semond et P. Soukiassian, demande de brevet français n° 9615435 du 16 décembre 1996 au nom de C.E.A. et C.N.R.S. (FR2757183A) - voir aussi WO98/2757 publié le 25 juin 1998.
[5] M. Riehl-Chudoba, P. Soukiassian et C. Jaussaud, J. Appl. Phys. 76, 1332 (1994).
[6] M. Reinl-Chudoba, S. Dupont et P. Soukiassian, Surf. Sci. 331-333, 625 (1995).
[7] M. Riehl-Chudoba, P. Soukiassian, C. Jaussaud et S. Dupont, Phys. Rev. B 51, 14300 (1995).
[8] F. Semond, P. Soukiassian, P.S. Mangat et L. di Cioccio, J. Vac. Sci. Tech. B 13, 1591 (1995).
[9] F. Semond, L. Douillard, P. Soukiassian, D. Dunham, F. Amy et S. Rivillon, Appl. Phys. Lett. 68, 2144 (1996).
[10] F. Semond, P. Soukiassian, P.S. Mangat, Z. Hurych, L. di Cioccio et C. Jaussaud, Appl. Surf. Sci. 104-105, 79 (1996).
[11] V.M. Bermudez, Phys. Stat. Sol. (b) 202, 447 (1997).
[12] J.M. Powers, A. Wander, P.J. Rous, M.A. Van Hove et G.A. Somorjai, Phys. Rev. B 44, 11159 (1991).
[13] J.P. Long, V.M. Bermudez et D.E. Ramaker, Phys. Rev. Lett. 76, 1991 (1996).
[14] F. Semond, P. Soukiassian, A. Mayne, G. Dujardin, L. Douillard et C. Jaussaud, Phys. Rev. Lett. 77, 2013 (1996).
[15] T. Aizawa, T. Ando, M. Kamo et Y. Sato, Phys. Rev. B 48, 18348 (1993).

## Revendications

1. Couche monoatomique et monocristalline de carbone de type diamant, cette couche étant **caractérisée en ce qu'**elle est formée sur la surface d'un substrat monocristallin en SiC et s'étend sensiblement sur la totalité de ce substrat (2).

2. Couche monoatomique et monocristalline selon la revendication 1, le substrat monocristallin en SiC étant une couche mince (2) de SiC monocristallin en phase cubique β-SiC (100) formée sur une plaquette de Si, la couche monoatomique et monocristalline recouvrant ainsi sensiblement la totalité de cette plaquette.

3. Couche monoatomique et monocristalline selon la revendication 1, le substrat monocristallin en SiC étant une plaquette de SiC monocristallin en phase hexagonale, la couche monoatomique et monocristalline recouvrant ainsi sensiblement la totalité de cette plaquette.

4. Couche monoatomique et monocristalline selon l'une quelconque des revendications 1 à 3, surmontée d'une couche monocristalline de diamant formée par croissance à partir de la couche monoatomique et monocristalline, cette dernière servant de matrice.

5. Procédé de fabrication d'une couche monoatomique et monocristalline de carbone de type diamant, ce procédé étant **caractérisé en ce qu'**on forme un substrat monocristallin en SiC terminé par un plan atomique de carbone selon une reconstruction c(2x2), ce plan étant un plan de dimères carbone-carbone (4) de configuration sp, et **en ce qu'**on effectue au moins un recuit de ce substrat, ce recuit étant apte à transformer le plan de dimères carbone-carbone (4) de configuration sp en un plan de dimères carbone-carbone (8) de configuration sp³ formant ainsi une couche monoatomique et monocristalline de carbone de type diamant.

6. Procédé selon la revendication 5, dans lequel le substrat monocristallin en SiC est préparé à partir d'une couche mince de SiC monocristallin en phase cubique β-SiC ayant une face (100) terminée par une couche de Si.

7. Procédé selon la revendication 5, dans lequel le substrat monocristallin en SiC est préparé à partir d'une plaquette de SiC monocristallin en phase hexagonale ayant une face (1000) terminée par une couche de Si.

8. Procédé selon l'une quelconque des revendications 6 et 7, dans lequel, pour obtenir le plan atomique de carbone selon la reconstruction c(2x2), on effectue un recuit apte à éliminer la couche de Si.

9. Procédé selon l'une quelconque des revendications 6 et 7, dans lequel, pour obtenir le plan atomique de carbone selon la reconstruction c(2x2), on effectue un dépôt de molécules hydrocarbonées sur la couche de Si puis un craquage de ces molécules.

10. Procédé selon la revendication 9, dans lequel les molécules hydrocarbonées sont choisies dans le groupe comprenant les molécules de C₂H₄ et les molécules de C₂H₂.

11. Procédé selon l'une quelconque des revendications 5 à 10, dans lequel, pour transformer le plan de dimères carbone-carbone de configuration sp en un plan de dimères carbone-carbone de configuration sp³, on effectue un recuit ou une pluralité de recuits successifs, à une température environ égale à 1250°C, du substrat monocristallin en SiC terminé par le plan atomique de carbone selon la reconstruction c(2x2), la durée totale de recuit étant supérieure ou environ égale à 25 minutes.

## Patentansprüche

1. Monoatomare und monokristalline Schicht aus Kohlenstoff vom Diamant-Typ, wobei diese Schicht **dadurch gekennzeichnet ist, dass** sie auf die Oberfläche eines monokristallinen Substrats aus SiC aufgebracht ist und sich im wesentlichen über die Gesamtheit dieses Substrats (2) erstreckt.

2. Monoatomare und monokristalline Schicht nach Anspruch 1, in der das monokristalline Substrat aus SiC eine dünne Schicht (2) aus monokristallinem SiC in der kubischen β-SiC-Phase (100) ist, die auf einen Si-Wafer aufgebracht ist, wobei die monoatomare und monokristalline Schicht auf diese Weise praktisch die Gesamtheit dieses Wafers bedeckt.

3. Monoatomare und monokristalline Schicht nach Anspruch 1, wobei das monokristalline Substrat aus SiC ein Wafer aus monokristallinem SiC in der hexagonalen Phase ist und die monoatomare und monokristalline Schicht auf diese Weise im wesentlichen die Gesamtheit dieses Wafers bedeckt.

4. Monoatomare und monokristalline Schicht nach einem der Ansprüche 1 bis 3, auf die eine monokristalline Schicht aus Diamant aufgebracht ist, die gebildet wurde durch Aufwachsen auf die monoatomare und monokristalline Schicht, die als Matrix diente.

5. Verfahren zur Herstellung einer monoatomaren und monokristallinen Schicht aus Kohlenstoff vom Diamant-Typ, wobei das Verfahren **dadurch gekennzeichnet ist, dass** man ein monokristallines Substrat aus SiC bildet, das nach einer C-Umlagerung (2x2) durch eine atomare Fläche aus Kohlenstoff abgeschlossen ist, wobei diese Fläche eine Fläche aus Kohlenstoff-Kohlenstoff-Dimeren (4) mit der Konfiguration sp ist und dieses Substrat mindestens einmal geglüht wird, das dazu bestimmt ist, die Fläche aus Kohlenstoff-Kohlenstoff-Dimeren (4) mit der Konfiguration sp in eine Fläche aus Kohlenstoff-Kohlenstoff-Dimeren (8) mit der Konfiguration sp³ zu überführen, wobei auf diese Weise eine monoatomare und monokristalline Schicht aus Kohlenstoff vom Diamant-Typ gebildet wird.

6. Verfahren nach Anspruch 5, bei dem das monokristalline Substrat aus SiC hergestellt wird aus einer dünnen Schicht aus monokristallinem SiC in der kubischen β-SiC-Phase, die eine Fläche (100) aufweist, die durch eine Si-Schicht abgeschlossen ist.

7. Verfahren nach Anspruch 5, bei dem das monokristalline Substrat aus SiC hergestellt wird aus einem monokristallinen SiC-Wafer in der hexagonalen Phase, der eine Fläche (1000) aufweist, die durch eine Si-Schicht abgeschlossen ist.

8. Verfahren nach einem der Ansprüche 6 und 7, bei dem zur Erzielung der atomaren Fläche aus Kohlenstoff nach der C-Umlagerung (2x2) ein Glühen durchgeführt wird, wodurch die Schicht aus Si eliminiert werden kann.

9. Verfahren nach einem der Ansprüche 6 und 7, bei dem zur Herstellung der atomaren Fläche aus Kohlenstoff nach der C-Umlagerung (2x2) eine Abscheidung von Kohlenwasserstoff-Molekülen auf der Si-Schicht und dann eine Crackung dieser Moleküle durchgeführt wird.

10. Verfahren nach Anspruch 9, in dem die Kohlenwasserstoff-Moleküle ausgewählt werden aus der Gruppe, die C₂H₄-Moleküle und C₂H₂-Moleküle umfasst.

11. Verfahren nach einem der Ansprüche 5 bis 10, in dem zur Überführung der Fläche aus Kohlenstoff-Kohlenstoff-Dimeren mit der Konfiguration sp in eine Fläche aus Kohlenstoff-Kohlenstoff-Dimeren mit der Konfiguration sp³ ein Glühen oder ein aufeinanderfolgendes mehrmaliges Glühen bei einer Temperatur von etwa 1250 °C des monokristallinen Substrats aus SiC, das durch die atomare Fläche aus Kohlenstoff nach der C-Umlagerung (2x2) abgeschlossen ist, durchgeführt wird, wobei die Gesamtdauer des Glühens ≥ 25 min beträgt.

## Claims

1. Monoatomic and monocrystalline layer of diamond type carbon, this layer being **characterised in that** it is formed on the surface of a monocrystalline substrate of SiC and extends closely over the totality of this substrate (2).

2. Monoatomic and monocrystalline layer according to claim 1, the SiC monocrystalline substrate being a thin layer (2) of monocrystalline SiC in cubic phase β-SiC (100) formed on a platelet of Si, the monoatomic and monocrystalline layer thus closely covering the totality of this platelet.

3. Monoatomic and monocrystalline layer according to claim 1, the monocrystalline substrate in SiC being a platelet of monocrystalline SiC in hexagonal phase, the monoatomic and monocrystalline layer thus closely covering the totality of this platelet.

4. Monoatomic and monocrystalline layer according to any one of claims 1 to 3, covered with a monocrystalline later of diamond formed by growth from the monoatomic and monocrystalline layer, the latter acting as matrix.

5. Manufacturing process of a monoatomic and monocrystalline layer of diamond type carbon, this process being **characterised in that** one forms a monocrystalline substrate in SiC terminated by a carbon atomic plane according to a c(2x2) reconstruction, this plane being a plane of carbon-carbon dimers (4) of sp configuration , and **in that** one carries out at least one annealing of this substrate, this annealing being able to transform the plane of carbon-carbon dimers (4) of sp configuration into a plane of carbon-carbon dimers (8) of sp³ configuration thus forming a monoatomic and monocrystalline layer of diamond type carbon.

6. Process according to claim 5, in which the SiC monocrystalline substrate is prepared from a thin layer of monocrystalline SiC in cubic phase β-SiC with a face (100) terminated by a layer of Si.

7. Process according to claim 5, in which the SiC monocrystalline substrate is prepared from a monocrystalline SiC platelet in hexagonal phase with a face (1000) terminated by a layer of Si.

8. Process according to any one of claims 6 and 7, in which, to obtain the atomic plane of carbon according to the reconstruction c(2x2), an annealing is carried out capable of eliminating the layer of Si.

9. Process according to one or the other of claims 6 and 7 in which, to obtain the atomic plane of carbon according to the reconstruction c(2x2), a deposit of hydrocarboned molecules is made on the Si layer followed by cracking of these molecules.

10. Process according to claim 9, in which the hydrocarboned molecules are chosen from among the group comprising the molecules of C₂H₄ and the molecules of C₂H₂.

11. Process according to any one of claims 5 to 10, in which, to transform the plane of carbon-carbon dimers of sp configuration into a plane of carbon-carbon dimers of sp³ configuration, one carries out an annealing or a plurality of successive annealings, at a temperature approximately equal to 1250°C, of the monocrystalline substrate in SiC terminated by the atomic plane of carbon according to the reconstruction c(2x2), the total time of annealing being greater than or about equal to 25 minutes.
